# EUROPEAN PATENT APPLICATION

(11) **EP 2 017 673 A1**
(43) Date of publication of application: **21.01.2009**
(21) Application number: 08160683.2
(22) Date of filing: 18.07.2008
(51) Int. Cl.: G03F 1/14

(54) **Pellicle frame**

(30) Priority: 19.07.2007 JP 2007188706
(71) Applicant: Shin-Etsu Chemical Co., Ltd., Tokyo (JP)
(72) Inventor: Shirasaki, Toru, Gunma-ken (JP)
(74) Representative: Peaucelle, Chantal

(57) **Abstract**

The present invention is directed to provide a pellicle frame that causes little harm to the flatness of a photomask, even in the case where a pellicle is affixed after completion of the photomask.

## Description

### BACKGROUND OF THE INVENTION

### 1. Field of the Invention

The present invention relates to a lithographic pellicle, in particular to a lithographic pellicle used as dust-proof protection in the manufacture of semiconductor devices such as LSI or ultra-LSI. More particularly, the invention relates to a lithographic pellicle frame used for ultraviolet exposure light of 200 nm or shorter wavelength used for patterning light exposure which requires high resolution.

### 2. Description of the Related Art

Conventionally, the manufacture of semiconductor devices such as LSI and ultra-LSI, or liquid crystal display panels and the like, has involved employing procedures such as lithography for the patterning of semiconductor wafers or liquid crystal original plates through irradiation of light. However, there is a problem that any dust adhering to the employed original plate absorbs and reflects light, which deforms and roughens the edges of the replicated patterning, thereby detracting from dimensions, quality, and appearance, and impairing the performance of the semiconductor device and/or liquid crystal display panel, while reducing the manufacturing yield thereof.

Thus, these operations are ordinarily carried out in clean rooms, but keeping exposure original plates clean at all times in such clean rooms is difficult, and hence pellicles having good light transmissivity are adhered, as dust-proof protection, to the surface of exposure original plates. The advantage of the pellicle is that dust does not attach directly to the surface of the exposure original plate, but becomes adhered to the pellicle membrane, so that if focus is in accord with the pattern of the exposure original plate during lithography, transfer is not affected by dust on the pellicle.

The pellicle is made up of a pellicle frame comprising aluminum, stainless steel, polyethylene or the like, a transparent pellicle membrane adhered on the upper surface of the pellicle frame, comprising nitrocellulose, cellulose acetate or the like having good light transmissivity, an adhesive layer coated on the lower surface of the pellicle frame, and a release layer (separator) adhered on the adhesive layer. The adhesive bonding between the pellicle frame and pellicle membrane is carried out by coating a good solvent for the pellicle membrane material and then air-drying the solvent (Japanese Patent Application Laid-open No. S58-219023) or using an adhesive agent such as an acrylic resin, epoxy resin or the like (US Patent No. 4861402, Japanese Patent Examined Application Publication No. S63-27707, Japanese Unexamined Patent Application Laid-open No. H07-168345).

As a result of ever higher lithography resolutions encountered in recent years, the employed light sources are gradually shifting to shorter wavelengths in order to realize such resolutions. Specifically, there has been a shift towards g-line (436 nm), i-line (365 nm), KrF excimer lasers (248 nm) in ultraviolet light, while ArF excimer lasers (193 nm) have begun to be used recently.

In a semiconductor exposure device, the pattern drawn on a photomask is burned onto a silicon wafer by way of short-wavelength light. Irregularities on the photomask and the silicon wafer give rise however to focal shift, which impairs the pattern printed onto the wafer. The required flatness from photomasks and silicon wafers is getting more stringent as the patterning becomes finer and finer. For instance, the required flatness from photomasks is becoming gradually more demanding, from a flatness of 2 µm at the pattern plane, down to 0.5 µm and 0.25 µm for the 65 nm node and beyond.

Pellicles are affixed onto finished photomasks as dust-proof protection of the latter. However, the flatness of a photomask may change upon affixing of a pellicle on the photomask. Deficient photomask flatness can give rise to problems such as the above-described focal shift. Changes in flatness alter the shape of the pattern drawn on the photomask and give rise also to problems as regards focal displacement on the photomask.

In contrast, photomask flatness may be improved by pellicle affixing. Although in this case focal shift is not a problem, pattern shape changes still give rise to problems as regards focal displacement on the photomask. In leading-art photomasks, thus, photomask flatness must not change when a pellicle is affixed. However, photomask flatness often changes when a pellicle is affixed thereto.

Pellicle frames are usually made of aluminum alloy. Pellicle frames have a width of about 150 mm, a length of about 110 to 130 mm, a height of about 4.5 mm and a thickness of about 2 mm, and have a shape with an opening in a central region. Generally, pellicle frames are manufactured by cutting a plate of aluminum alloy into the pellicle frame shape, or extrusion molding of aluminum alloy material into the pellicle frame shape.
The flatness of the pellicle frame ranges ordinarily from about 20 to 80 µm. When a pellicle using a frame having such substantial flatness is affixed onto a photomask, however, the shape of the frame becomes transferred to the photomask, deforming the latter.

During affixing onto the photomask, the pellicle is pressed against the photomask with a substantial force, of about 196.1 to 392.2 N (20 to 40 kgf). Herein, a photomask surface having a flatness no greater than several µm is flatter than the frame, and the rigidity of the framework is also high, and hence the frame is assumed to undergo elastic deformation to a flat state when pressed against the photomask. Therefore, investigations are being done to reduce the deformation of the photomask during the pellicle affixation by improving the flatness of the pellicle frame to reduce the deformation of the pellicle frame; but in the case of a pellicle frame made of aluminum alloy, it is difficult to manufacture a pellicle frame having the flatness of 15 µm or less of the pellicle frame.

In consideration of the circumstances recited above, the present invention is directed to provide a pellicle frame that causes little harm to the flatness of a photomask, even in the case where a pellicle is affixed after completion of the photomask.

### SUMMARY OF THE INVENTION

The pellicle used in semiconductor lithography in accordance with the present invention is characterized in that a pellicle frame is made of a material having a Young's modulus of at least 100 GPa. Furthermore, the pellicle used in semiconductor lithography is characterized in that the flatness of at least one end face of the pellicle frame is no more than 15 µm.

According to the present invention, a material used in the pellicle frame has a large Young's modulus, and additionally, the flatness of the pellicle frame is improved, thereby enabling an improvement of the resistance of the pellicle frame to deformation due to stress accompanying affixing/drying of the pellicle, and therefore enabling marked improvement of the flatness of the photomask after the pellicle is affixed.

### DESCRIPTION OF PREFERRED EMBODIMENTS

The inventor of the present invention, as a result of investigation of the properties of the pellicle frame affecting deformation of the photomask, discovered that manufacturing the pellicle frame from a material having a Young's modulus exceeding 100 GPa and additionally controlling the flatness of the pellicle frame to 15 µm or less, more effectively controls the deformation of the photomask. As recited above, generally aluminum is used in current pellicle frames and has a relatively low Young's modulus among metals which, combined with the shape of the pellicle generally having a width of only 2 mm, in the case where a large force of about 294.2N (30 kgf) is applied during pellicle affixation, deformation unfortunately occurs relatively easily.

However, in the case where a material having a Young's modulus exceeding 100 GPa is used, even when such a large force is applied, the deformation is small compared to that of aluminum alloy. Even in the case where a material having a Young's modulus exceeding 100 GPa is used, if the flatness of the pellicle frame is poor, the pellicle frame unfortunately deforms somewhat during affixation of the pellicle. Moreover, the deformation of the pellicle frame brings about deformation of the photomask. A better flatness of the pellicle frame results in a correspondingly smaller effect on the flatness of the photomask. Moreover, in the case where the pellicle frame is manufactured using a material having a Young's modulus exceeding 100 GPa, controlling the flatness to 15 µm or less enables the variation of the flatness of the photomask to be controlled at a realistically sufficiently low value.

Furthermore, generally grinding is performed during fabrication to achieve a good flatness, but unfortunately in the case of materials having a low Young's modulus, good flatness is generally difficult to achieve. Here, using a material having a Young's modulus exceeding 100 GPa allows good flatness to be achieved relatively easily. Examples of materials having Young's modulus exceeding 100 GPa include carbon steel (206 GPa), stainless steel (SUS 304, 199 GPa), and titanium alloy (Ti-6Al-4V, 113 GPa). Additionally, for example some composites may exhibit a very large Young's modulus; for example, carbon fiber reinforced magnesium alloy may exhibit a value of 539 GPa.

### EXAMPLES

Examples of the present invention are explained below, although the invention is in no way meant to be limited to or by these examples.

### Example 1

A 5% solution of Cytop CTX-S (product name, Asahi Glass Co.) dissolved in perfluorotributylamine was dripped onto a silicone wafer, and was spread thereon by rotating the wafer at 830 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

A pellicle frame was manufactured of SUS 304 stainless steel with outer dimensions of 149 mm x 122 mm x 5.8 mm. The flatness of the pellicle frame as measured on a side to be applied with the photomask adhesive was 30 µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The finished pellicle was affixed, under a load of about 196 kN (20 kgf), onto a 142 mm square photomask having a flatness of 0.26 µm. The flatness of the pellicle-bearing photomask was then measured again, to yield 0.30 µm. Although worse by 0.04 µm, flatness was successfully kept low. Furthermore, regarding the shape of the photomask, no large change had occurred. The measurement results of the flatness are presented, together with those of the following Examples and Comparative Example, in Table 1.

### Example 2

A 5% solution of Cytop CTX-S (product name, Asahi Glass Co.) dissolved in perfluorotributylamine was dripped onto a silicone wafer, and was spread thereon by rotating the wafer at 830 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

A pellicle frame was manufactured of SUS 304 stainless steel with outer dimensions of 149 mm x 122 mm x 5.8 mm. The flatness of the pellicle frame as measured on a side to be applied with the photomask adhesive was 15µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The finished pellicle was affixed, under a load of about 196 kN (20 kgf), onto a 142 mm square photomask having a flatness of 0.26 µm. The flatness of the pellicle-bearing photomask was then measured again, to yield 0.27 µm, and exhibited virtually no change. Furthermore, regarding the shape of the photomask, no large change had occurred.

### Example 3

A 5% solution of Cytop CTX-S (product name, Asahi Glass Co.) dissolved in perfluorotributylamine was dripped onto a silicone wafer, and was spread thereon by rotating the wafer at 830 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

A pellicle frame was manufactured of titanium alloy with outer dimensions of 149 mm x 122 mm x 5.8 mm. The flatness of the pellicle frame as measured on a side to be applied with the photomask adhesive was 15µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The finished pellicle was affixed, under a load of about 196 kN (20 kgf), onto a 142 mm square photomask having a flatness of 0.26 µm. The flatness of the pellicle-bearing photomask was then measured again, to yield 0.29 µm, and exhibited virtually no change. Furthermore, regarding the shape of the photomask, no large change had occurred.

### Comparative Example 1

A 5% solution of Cytop CTX-S (product name, Asahi Glass Co.) dissolved in perfluorotributylamine was dripped onto a silicone wafer, and was spread thereon by rotating the wafer at 830 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

A pellicle frame was manufactured of aluminum having undergone a surface anodizing treatment with outer dimensions of 149 mm x 122 mm x 5.8 mm. The flatness of the pellicle frame as measured on a side to be applied with the photomask adhesive was 30µm. One end face of the pellicle frame was applied with the photomask adhesive, and another end face was applied with a film bonding agent. Then, the previously peeled-off pellicle film was affixed to the film bonding agent side of the aluminum alloy frame, and the film of the outer circumference of the pellicle frame was trimmed, thus completing the pellicle.

The finished pellicle was affixed, under a load of about 196 kN (20 kgf), onto a 142 mm square photomask having a flatness of 0.26 µm. The flatness of the pellicle-bearing photomask was then measured again, to yield 0.39 µm. Photomask flatness worsened thus considerably.

**Table 1 - Flatness measurement results**

| | Material | Young's modulus | Frame flatness (µm) | Photomask flatness(µ m) | | |
|---|---|---|---|---|---|---|
| | | | | Before affixing | After affixing | Deformation |
| Example 1 | SUS 304 | 199 | 30 | 0.26 | 0.30 | + 0.04 |
| Example 2 | SUS 304 | 199 | 15 | 0.26 | 0.27 | + 0.01 |
| Example 3 | titanium alloy | 113 | 15 | 0.26 | 0.29 | + 0.03 |
| Comparative Example 1 | aluminum | 69 | 30 | 0.26 | 0.39 | + 0.13 |

According to the present invention, deterioration of the flatness of the photomask after pellicle affixation, for which no method of avoidance has been found by conventional art, can be drastically improved; and therefore areas of contribution are great in technical fields using photomask/pellicle lithography technology.

## Claims

1. A pellicle used in semiconductor lithography, **characterized in that** a pellicle frame is made of a material having a Young's modulus of at least 100 GPa.

2. A pellicle according to claim 1, wherein the flatness of at least one end face of the pellicle frame is no more than 15µm.
